# EUROPEAN PATENT APPLICATION

(11) **EP 4 513 546 A1**
(43) Date of publication of application: **26.02.2025**
(21) Application number: 23791815.6
(22) Date of filing: 17.04.2023
(51) Int. Cl.: H01L 23/12, H01L 23/13, H01L 23/36, H05K 1/02, H05K 7/20

(54) **CERAMIC CIRCUIT BOARD, SEMICONDUCTOR DEVICE, AND SEMICONDUCTOR DEVICE PRODUCTION METHOD**

(30) Priority: 20.04.2022 JP 2022069200
(71) Applicant: Kabushiki Kaisha Toshiba, Tokyo 105-0023 (JP); Toshiba Materials Co., Ltd., Isogo-Ku Yokohama-Shi Kanagawa 235-0032 (JP)
(72) Inventor: UENO, Toshihide, Yokohama-shi, Kanagawa 235-0032 (JP)
(74) Representative: Henkel & Partner mbB
(86) International application number: PCT/JP2023/015288
(87) International publication number: WO 2023/204167

(57) **Abstract**

A ceramic circuit board according to an embodiment comprises a ceramic substrate and metal sheets joined to either surface of the ceramic substrate. At least one of the metal sheets joined to either surface of the ceramic substrate is a cooling path metal sheet having a cooling path part. The thickness of the ceramic substrate is preferably less than the thickness of the cooling path metal sheet. It is preferable that the ceramic substrate comprises a first ceramic substrate and a second ceramic substrate which is joined to a metal sheet joined to the first ceramic substrate, wherein one surface of the second ceramic substrate is joined to a cooling path metal sheet joined to the first ceramic substrate, and a metal sheet is joined to the other surface of the second ceramic substrate.

## Description

### TECHNICAL FIELD

An embodiment which will be described later generally relates to a ceramic circuit board, a semiconductor device, and a method for using the semiconductor device.

### BACKGROUND ART

With the advancement in performance of industrial equipment, output of power modules to be mounted on the industrial equipment has increased in recent years. Output of semiconductor elements has increased accordingly. Operation guaranteed temperatures of semiconductor elements range from 125 degrees Celsius to 150 degrees Celsius, but can be raised to more than or equal to 175 degrees Celsius in the future with the increase in output. A ceramic circuit board is used as a circuit board on which a semiconductor element is to be mounted. The ceramic circuit board is obtained by bonding a metal plate onto a ceramic substrate. In Japanese Patent No. 6789955 (Patent Document 1), for example, a circuit board includes a protruding portion which is a portion of a bonding layer protruding from a metal plate end. Patent Document 1 improves TCT characteristics (heat cycle resistance characteristics) by controlling the bonding layer protruding portion in hardness and size.

In order to improve the cooling efficiency of a semiconductor element which is a heating element, a method for using cooling water is being studied. In Japanese Patent Laid-Open No. 2001-148451 (Patent Document 2), for example, a heat sink on which a ceramic circuit board is to be mounted is provided with a water passage to dissipate heat produced from a semiconductor element. In International Publication No. 2015/147071 (Patent Document 3), a ceramic substrate is provided with a water passage.

### PRIOR ART DOCUMENTS

### PATENT DOCUMENT

Patent Document 1: Japanese Patent No. 6789955
Patent Document 2: Japanese Patent Laid-Open No. 2001-148451
Patent Document 3: International Publication No. 2015/147071

### SUMMARY OF THE INVENTION

### PROBLEMS TO BE SOLVED BY THE INVENTION

Since water cooling can be performed in Patent Documents 2 and 3, the cooling efficiency of the semiconductor elements is improved. However, Patent Document 2 leads to a size increase of the heat sink, which is unsuitable for size reduction of a module. Three-dimensionally shaping a ceramic substrate as in Patent Document 3 causes cost increase.

The embodiment solves such problems and relates to the ceramic circuit board that can improve the cooling efficiency of the semiconductor element and that can provide a ceramic circuit board having good productivity.

### MEANS FOR SOLVING THE PROBLEMS

A ceramic circuit board according to the embodiment includes: a ceramic substrate; and metal plates each bonded to both surfaces of the ceramic substrate. The metal plate bonded to at least one of both the surfaces of the ceramic substrate is a cooling passage metal plate including a cooling passage portion.

### BRIEF DESCRIPTION OF THE DRAWINGS

FIG. 1 is a side view showing an example of a ceramic circuit board according to an embodiment.
FIG. 2 is a side view showing another example of the ceramic circuit board according to the embodiment.
FIG. 3 is a drawing showing an example of a cooling passage portion.
FIG. 4 is a drawing showing another example of the cooling passage portion.
FIG. 5 is a side view showing an example of a semiconductor device according to the embodiment.
FIG. 6 is a side view showing another example of the semiconductor device according to the embodiment.

### DESCRIPTION OF EMBODIMENTS

Hereinafter, an embodiment of a ceramic circuit board, a semiconductor device, and a method for using the semiconductor device will be described in detail with reference to the drawings.

A ceramic circuit board according to the embodiment includes a ceramic substrate and metal plates each bonded to both surfaces of the ceramic substrate. The metal plate bonded to at least one of both the surfaces of the ceramic substrate is a metal plate (hereinafter referred to as a "cooling passage metal plate") including a cooling passage portion.

The number of components such as a heat sink can be reduced by providing the metal plate bonded to the ceramic substrate with the cooling passage portion.

In the ceramic circuit board according to the embodiment, it is desirable that the ceramic substrate should have a thickness smaller than a thickness of the cooling passage metal plate. In other words, it is preferable that the ceramic circuit board should satisfy a condition of (the thickness of the ceramic substrate) < (the thickness of the cooling passage metal plate).

The ceramic circuit board according to the embodiment includes a first ceramic substrate and a second ceramic substrate bonded to a metal plate bonded to the first ceramic substrate. It is preferable that one of surfaces of the second ceramic substrate should be bonded to the cooling passage metal plate bonded to the first ceramic substrate, a metal plate should be bonded to another of the surfaces of the second ceramic substrate, and the second ceramic substrate should have a thickness smaller than the thickness of the cooling passage metal plate. The ceramic substrates usually have a flat-plate shape. The ceramic substrates may have a three-dimensional structure partially having unevenness. In the case where the ceramic substrates have the three-dimensional structure, the thickness of the ceramic substrates indicates a thinnest portion in portions bonded to the metal plates.

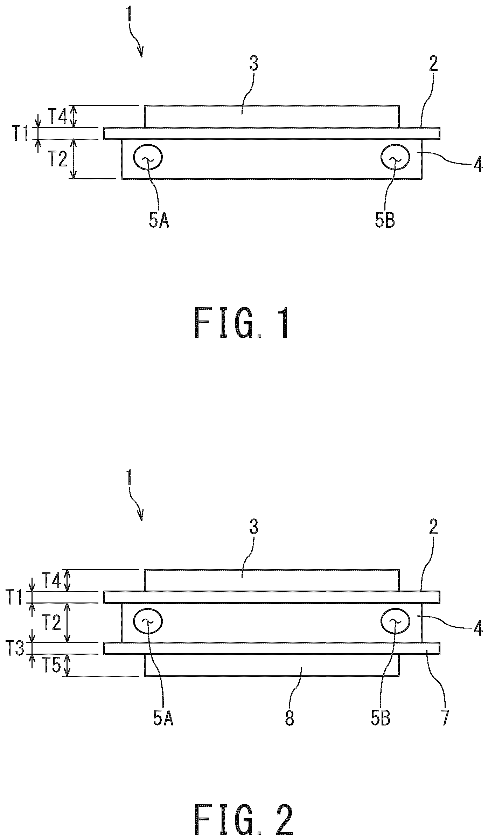

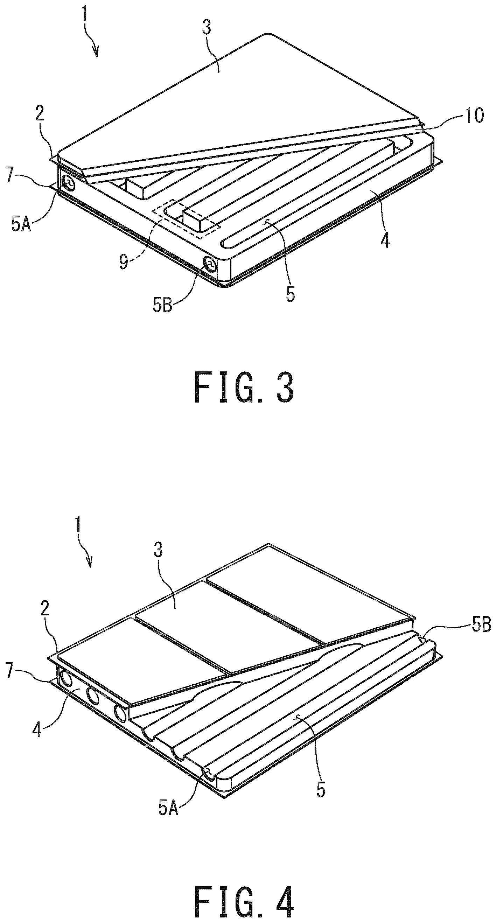

FIGS. 1 and 2 show examples of the ceramic circuit board according to the embodiment. In the drawings, reference numeral 1 denotes the ceramic circuit board, reference numeral 2 denotes the first ceramic substrate of the ceramic substrates, reference numerals 3 and 8 denote metal plates (hereinafter referred to as "non-cooling passage metal plates") not including a cooling passage portion among the metal plates, reference numeral 4 denotes the cooling passage metal plate among the metal plates, reference numeral 5 (shown in FIG. 3 and the like) denotes the cooling passage portion, reference numeral 5A denotes an entrance of the cooling passage portion 5, reference numeral 5B denotes an exit of the cooling passage portion 5, and reference numeral 7 denotes the second ceramic substrate of the ceramic substrates.

FIG. 1 shows a structure in which the non-cooling passage metal plate 3 is bonded to one of surfaces of the first ceramic substrate 2 and the cooling passage metal plate 4 is bonded to another of the surfaces on the opposite side. FIG. 2 shows a structure in which the non-cooling passage metal plate 3 is bonded to one of the surfaces of the first ceramic substrate 2, the cooling passage metal plate 4 is bonded to another of the surfaces, one of surfaces of the second ceramic substrate 7 is bonded to the cooling passage metal plate 4, and the non-cooling passage metal plate 8 is bonded to another of the surfaces of the second ceramic substrate 7. Although not shown, a structure may be adopted in which the cooling passage metal plates 4 are provided on both the surfaces of the first ceramic substrate 2. In that case, a through-hole may be provided in the first ceramic substrate 2, and cooling passage portions in the front and rear cooling passage metal plates 4 may be connected via the through-hole.

Examples of the ceramic substrates 2, 7 include a silicon nitride substrate, an aluminum nitride substrate, an alumina substrate, a zirconia substrate, and an alumina-zirconia substrate. The alumina-zirconia substrate refers to a ceramic sintered body in which alumina and zirconia have been blended.

It is preferable that a thickness T1 of the first ceramic substrate 2 and a thickness T3 of the second ceramic substrate 7 should fall within a range of more than or equal to 0.2 mm and less than or equal to 4 mm. If the thicknesses T1, T3 of the ceramic substrates 2, 7 are less than 0.2 mm, the strength might be insufficient. If the thicknesses T1, T3 of the ceramic substrates 2, 7 exceed 4 mm, heat dissipation performance might degrade. Thus, it is preferable that the thicknesses T1, T3 of the ceramic substrates 2, 7 should fall within the range of more than or equal to 0.2 mm and less than or equal to 4 mm and further, in a case where the ceramic substrates 2, 7 are silicon nitride substrates or aluminum oxide substrates, the thicknesses T1, T3 should fall within a range of more than or equal to 0.2 mm and less than or equal to 1 mm. In the case shown in FIG. 2, the thickness T1 of the first ceramic substrate 2 and the thickness T3 of the second ceramic substrate 7 may be equal or may not be equal.

It is preferable that the silicon nitride substrates used as the ceramic substrates 2, 7 should have a three-point bending strength of more than or equal to 600 MPa. It is preferable that the silicon nitride substrates should have a thermal conductivity of more than or equal to 80 W/m•K. The substrate thickness can be reduced by increasing the strength of the silicon nitride substrates. Thus, it is preferable that the silicon nitride substrates should have a three-point bending strength of more than or equal to 600 MPa and further, more than or equal to 700 MPa. The silicon nitride substrates can have a small substrate thickness of less than or equal to 2 mm and further, less than or equal to 0.40 mm.

The aluminum nitride substrates used as the ceramic substrates 2, 7 have a three-point bending strength of approximately 300 to 450 MPa. On the other hand, the aluminum nitride substrates have a thermal conductivity of more than or equal to 160 W/m•K. Since the aluminum nitride substrates are low in strength, it is preferable that the substrate thickness should be more than or equal to 0.60 mm.

The aluminum oxide substrates used as the ceramic substrates 2, 7 are inexpensive although having a three-point bending strength of approximately 300 to 450 MPa. The alumina-zirconia substrates have a high three-point bending strength of approximately 550 MPa but have a thermal conductivity of approximately 30 to 50 W/m•K.

It is preferable that the ceramic substrates 2, 7 should be silicon nitride substrates. One reason is that the silicon nitride substrates are high in strength and can thus be reduced in thickness. Another reason is that the use of the silicon nitride substrates having a thermal conductivity of more than or equal to 80 W/m•K can also improve heat dissipation performance.

Examples of the metal plates, that is, the non-cooling passage metal plates 3, 8 and the cooling passage metal plate 4 include one or two or more types selected from among a copper plate, a copper alloy plate, an aluminum plate, and an aluminum alloy plate. It is preferable to use copper plates as the metal plates. It is more preferable that the copper plates should be oxygen-free copper plates. Oxygen-free copper has a copper purity of more than or equal to 99.96 wt% as indicated in JIS-H-3100. Copper has a thermal conductivity of about 400 W/m•K, and aluminum has a thermal conductivity of about 240 W/m•K. Since copper is higher in thermal conductivity than aluminum, heat dissipation performance is improved. It is preferable that the aluminum plate should be pure aluminum. Pure aluminum is indicated in JIS-H-4000. The aluminum plate is suitable for weight reduction. JIS-H-4000 corresponds to ISO 6361. JIS-H-3100 corresponds to ISO 197 and the like.

The number of components such as a heat sink for dissipating heat produced from a semiconductor element can be reduced by providing the metal plates bonded to the ceramic substrates 2, 7 with the cooling passage portion 5 (shown in FIG. 3).

In the ceramic circuit board 1 according to the embodiment, the thickness T1 of the first ceramic substrate 2 is smaller than a thickness T2 of the cooling passage metal plate 4. In other words, the ceramic circuit board 1 satisfies the condition of T1 < T2. In the ceramic circuit board 1, it is preferable that the thickness T3 of the second ceramic substrate 7 should also be smaller than the thickness T2 of the cooling passage metal plate 4. In other words, it is preferable that the ceramic circuit board 1 should satisfy a condition of T3 < T2. T1 indicates the thickness of the first ceramic substrate 2, T2 indicates the thickness of the cooling passage metal plate 4, and T3 indicates the thickness of the second ceramic substrate 7.

The cooling passage metal plate 4 dissipates heat by circulating a cooling medium such as cooling water in the cooling passage portion 5 or bringing the cooling medium into contact with the cooling passage portion 5 (shown in FIG. 3). The heat dissipation performance of the cooling passage metal plate 4 can be improved by satisfying the condition of T1 < T2. The heat dissipation performance of the cooling passage metal plate 4 can also be improved by satisfying the condition of T3 < T2. As will be described later, the non-cooling passage metal plate 3 or the non-cooling passage metal plate 8 can be used for a circuit portion on which a semiconductor element is to be mounted. Comparing a ceramic substrate and a metal plate, the metal plate is higher in thermal conductivity. The heat dissipation performance can be improved by satisfying the condition of T1 < T2. The heat dissipation performance can also be improved similarly by satisfying the condition of T3 < T2. At least one of the non-cooling passage metal plate 3 and the non-cooling passage metal plate 8 may be replaced by a cooling passage metal plate, and the cooling passage metal plate may be used for the circuit portion on which a semiconductor element is to be mounted.

It is preferable that a ratio of the thickness T2 of the cooling passage metal plate 4 to the thickness T1 of the first ceramic substrate 2, that is, T2/T1, should fall within a range of more than or equal to 2 and less than or equal to 40. It is preferable that a ratio of the thickness T2 of the cooling passage metal plate 4 to the thickness T3 of the second ceramic substrate 7, that is, T2/T3, should fall within a range of more than or equal to 2 and less than or equal to 20. The heat dissipation performance and prevention of warpage can both be achieved by satisfying one or both of conditions of 2 ≤ T2/T1 ≤ 40 and 2 ≤ T2/T3 ≤ 40.

A ceramic circuit board and a heat sink including a cooling passage portion have conventionally been provided separately as in Patent Document 2. The ceramic circuit board 1 according to the embodiment can have a structure in which a heat sink is not used because the metal plate 4 bonded to the ceramic substrates 2, 7 is provided with the cooling passage structure. Thus, the effect of reducing the number of components can be obtained as a semiconductor device.

It is preferable that the thickness T2 of the cooling passage metal plate 4 should be more than or equal to 1 mm. When the thickness T2 of the cooling passage metal plate 4 is more than or equal to 1 mm, it is easier to form the cooling passage portion 5 in the metal plate 4. An upper limit of the thickness T2 of the cooling passage metal plate 4 is not particularly limited and preferably is less than or equal to 20 mm. When the thickness T2 is as large as more than 20 mm, the ceramic circuit board 1 might be increased in size. Thus, it is preferable that the thickness T2 should be more than or equal to 1 mm and less than or equal to 20 mm and further, in the case where the ceramic substrates 2, 7 are silicon nitride substrates, the thickness T2 should be more than or equal to 3 mm and less than or equal to 10 mm.

A thickness of the non-cooling passage metal plate 3 is denoted by T4, and a thickness of the non-cooling passage metal plate 8 is denoted by T5. The thicknesses T4, T5 of the non-cooling passage metal plates 3, 8 may be equal or may not be equal, and are each preferably more than or equal to 0.2 mm. The non-cooling passage metal plates 3, 8 become circuit portions on which a semiconductor element is to be mounted. The non-cooling passage metal plates 3, 8 are metal plates not including the cooling passage portion 5. A current-carrying capacity and heat dissipation performance can be provided by thickening the metal plates. An upper limit of the thicknesses of the non-cooling passage metal plates 3, 8 is not particularly limited and preferably is less than or equal to 10 mm. When the thicknesses of the non-cooling passage metal plates 3, 8 exceed 10 mm, the ceramic circuit board 1 might be increased in size. Besides, it might be difficult to form a circuit shape. FIGS. 1 and 2 illustrate the ceramic circuit boards with the single non-cooling passage metal plate 3 bonded to one of the surfaces of the first ceramic substrate 2 and the single non-cooling passage metal plate 8 bonded to one of the surfaces of the second ceramic substrate 7. However, the ceramic circuit board 1 according to the embodiment is not limited to such a form, and a plurality of the non-cooling passage metal plates 3 (bonding of three non-cooling passage metal plates 3 is illustrated in FIG. 4) may be provided on one of the surfaces of the ceramic substrate 2 or 7. In other words, the non-cooling passage metal plates 3, 8 may be given a circuit shape.

It is preferable that a ratio of the thickness T2 of the cooling passage metal plate 4 to the thickness T4 of the non-cooling passage metal plate 3, that is, T2/T4, should fall within a range of more than or equal to 0.5 and less than or equal to 50. The effect of preventing warpage of the ceramic circuit board 1 can be obtained by decreasing a difference between the thickness T2 of the cooling passage metal plate 4 and the thickness T4 of the non-cooling passage metal plate 3 to some degree to satisfy the condition of 0.5 ≤ T2/T4 ≤ 50.

It is preferable that the ceramic circuit board 1 should be provided with the second ceramic substrate 7 and the non-cooling passage metal plate 8 as shown in FIG. 2. The ceramic circuit board 1 shown in FIG. 2 has a structure in which ceramic substrates are bonded to both the surfaces of the cooling passage metal plate 4. Flatness of the ceramic circuit board 1 can be improved by bonding the ceramic substrates 2, 7 to both the surfaces of the cooling passage metal plate 4. The flatness of the ceramic circuit board 1 is indicated by a difference between a highest location and a lowest location of a surface of the non-cooling passage metal plate 3. Similarly, the flatness of the ceramic circuit board 1 is indicated by a difference between a highest location and a lowest location of a surface of the non-cooling passage metal plate 8. The flatness can be made less than or equal to 1.0 mm by adopting the structure in which the ceramic substrates 2, 7 are bonded to both the surfaces of the cooling passage metal plate 4. The use of silicon nitride substrates also enables the flatness to be improved. The flatness can be measured using a three-dimensional shape measuring machine. The flatness indicates a difference between a highest location and a lowest location of a metal plate. For example, a highest location and a lowest location of the cooling passage metal plate 4 are measured, and a difference between the locations is used as the flatness.

Similarly to the ratio of the thickness T2 of the cooling passage metal plate 4 to the thickness T4 of the non-cooling passage metal plate 3, it is preferable that a ratio of the thickness T2 of the cooling passage metal plate 4 to the thickness T5 of the non-cooling passage metal plate 8, that is, T2/T5, should fall within a range of more than or equal to 0.5 and less than or equal to 50. The effect of preventing warpage of the ceramic circuit board 1 can be obtained by decreasing a difference between the thickness T2 of the cooling passage metal plate 4 and the thickness T5 of the non-cooling passage metal plate 8 to some degree to satisfy the condition of 0.5 ≤ T2/T5 ≤ 50.

The cooling passage metal plate 4 includes a cavity portion because of being provided with the cooling passage portion 5. Thus, distortion is likely to occur in the cooling passage metal plate 4. Therefore, distortion of the cooling passage metal plate 4 can be prevented by providing the ceramic substrates 2, 7 and the metal plates 3, 8 on both the surfaces of the cooling passage metal plate 4. Mounting performance of a semiconductor element 11 can be made better by preventing distortion of the cooling passage metal plate 4.

In the cooling passage metal plate 4, the entrance 5A and the exit 5B of the cooling passage portion 5 may be provided on the same side surface of the cooling passage metal plate 4 (as shown in FIG. 3) or on different side surfaces of the cooling passage metal plate 4 (as shown in FIG. 4). Positions of the entrance 5A and the exit 5B of the cooling passage portion 5 shall be determined in accordance with a place in which a semiconductor device 12 is to be installed and a mechanism that introduces cooling water. It is preferable that the cooling passage portion 5 of the cooling passage metal plate 4 should include a plurality of bent portions (for example, folded portions 9). Particularly in the case where the entrance 5A and the exit 5B of the cooling passage portion 5 are provided on the same side surface of the cooling passage metal plate 4 (as shown in FIG. 3), it is preferable that the cooling passage portion 5 should include the folded portions 9.

FIGS. 3 and 4 illustrate examples of the cooling passage portion. In the drawings, reference numeral 4 denotes the cooling passage metal plate, reference numeral 5 denotes the cooling passage portion, reference numeral 5A denotes the entrance of the cooling passage portion 5, reference numeral 5B denotes the exit of the cooling passage portion 5, reference numeral 9 denotes the folded portion, and reference numeral 10 denotes a lid portion. FIGS. 3 and 4 are schematic diagrams showing cut models for describing the structure of the cooling passage portion 5.

Various shapes can be applied to a shape formed by a flow passage of the cooling passage portion 5. The shape formed by the flow passage of the cooling passage portion 5 may be of a curved type including bent portions (for example, the folded portions 9) as shown in FIG. 3. The flow passage of the curved type may be a meandering structure made by the plurality of folded portions 9 as shown in FIG. 3, or may be a structure including bent portions having a U-shape, a V-shape, a W-shape, an L-shape, or the like. The flow passage of the cooling passage portion 5 may be of a linear type as shown in FIG. 4. A plurality of the cooling passage portions 5 may be provided. The curved and linear types may be combined. The cooling passage portion 5 may be a structure in which a plurality of cooling passages are intersected. When viewed as the structure of the single cooling passage portion 5, the flow passage is not limited to the linear type and may be corrugated. The cooling passage portion 5 may include a fin structure or may adopt a vapor chamber system.

The cooling passage portion 5 may be such a structure that passes through a region of the cooling passage metal plate 4 close to the semiconductor element 11 mounted on the non-cooling passage metal plates 3, 8, such as a region immediately under the semiconductor element 11. This enables heat from the semiconductor element 11 to be effectively cooled to improve the cooling efficiency.

In the cooling passage metal plate 4, the entrance 5A and the exit 5B of the cooling passage portion 5 may be provided on the same side surface of the cooling passage metal plate 4. In the structure in which the entrance 5A and the exit 5B are provided on the same side surface of the cooling passage metal plate 4, the cooling passage portion 5 has a continuous structure in which the single entrance 5A and the single exit 5B are connected when the cooling passage portion 5 is laid out all over the cooling passage metal plate 4. This facilitates management of the cooling medium. For example, when a plurality of the cooling passage portions 5 of the linear type are provided as shown in FIG. 4, a plurality of the entrances 5A and a plurality of the exits 5B are required. When the plurality of the entrances 5A and the plurality of the exits 5B are formed, the burden of management of the cooling medium increases. In a case where the cooling passage portion 5 is provided immediately under a location in which a plurality of semiconductor elements are to be mounted, a plurality of the cooling passage portions 5 are required when the cooling passage portions 5 are of the linear type as shown in FIG. 4.

The cooling passage portion 5 of the curved type in which the single entrance 5A and the single exit 5B are connected as shown in FIG. 3 facilitates management of the cooling medium and can increase the flexibility of the location in which semiconductor elements are to be mounted. Thus, it is preferable to use the cooling passage portion 5 including the folded portions 9. Although FIG. 3 shows the entrance 5A on the left side of the sheet of drawing and the exit 5B on the right side of the sheet of drawing, this is not a limitation. Although FIG. 4 shows the entrance 5A on the near side of the sheet of drawing and the exit 5B on the far side of the sheet of drawing, this is not a limitation. FIGS. 3 and 4 illustrate the entrance 5A and the exit 5B having a circular cross-section. However, the vicinities of the entrance 5A and the exit 5B are not limited to the case of presenting circular cross-sections and may have a rectangular or an elliptical shape or may have various shapes such as a U-shaped groove or V-shaped groove formed from one surface side or both surface sides. As shown in FIG. 4, the entrance 5A and the exit 5B of the cooling passage portion 5 may be provided on the different side surfaces of the cooling passage metal plate 4.

The cooling passage portion 5 formed in the cooling passage metal plate 4 should only be formed by any one or two or more types of one of the surfaces, both the surfaces, and the inside of the cooling passage metal plate 4. The cooling passage portion 5 shown in FIG. 3 is formed in the inside so as to have a circular cross-section in the vicinities of the entrance 5A and the exit 5B, and in a main body portion other than the entrance 5A and the exit 5B, a U-groove (a groove having a rectangular cross-section or having a rounded rectangular deep portion) is formed on one surface. On the other hand, the cooling passage portion 5 shown in FIG. 4 is formed in the inside so as to have a circular cross-section. In other words, in the example of FIG. 4, the cooling passage portion 5 is formed by boring a hole (tunnel) from the circular cut end in the side surface of the cooling passage metal plate 4 in the flow passage direction.

The cooling passage portion 5 formed on one of the surfaces of the cooling passage metal plate 4 is shaped by forming a groove from the one surface side of the cooling passage metal plate 4. The cooling passage portion 5 formed on both the surfaces of the cooling passage metal plate 4 is shaped by forming grooves respectively from both surface sides. In the case of providing the grooves on both the surfaces of the cooling passage metal plate 4, the grooves may have the same shape in front and rear surfaces or may have different shapes. The cooling passage portion 5 formed inside the cooling passage metal plate 4 is shaped by boring a hole (tunnel) from a side surface of the cooling passage metal plate 4 in the flow passage direction. In the case of the cooling passage portion 5 borne in this way, the cooling medium can be prevented from leaking out of the cooling passage portion 5 as the front and rear surfaces are not opened.

On the other hand, in the case of providing the cooling passage portion 5 formed by the groove/grooves borne from the one surface side or both the surface sides of the cooling passage metal plate 4, the cooling medium may be likely to leak out of the cooling passage portion 5 as the front and rear surfaces are not closed. Thus, a metal plate as the lid portion 10 that covers the groove/grooves formed in the cooling passage metal plate 4 may be bonded to the cooling passage metal plate 4 according to necessity. For providing the cooling passage portion 5 including the folded portions 9, it is effective to subject the one surface side or both the surface sides of the cooling passage metal plate 4 to groove processing. The cooling passage metal plate 4 might cause an insufficient bonding area with the ceramic substrate 2. The flatness of the non-cooling passage metal plates 3, 8 can be improved by providing the lid portion 10. Locations of the non-cooling passage metal plates 3, 8 immediately above a location in which the cooling passage portion 5 is provided are likely to be dented. Thus, the flatness of the non-cooling passage metal plates 3, 8 might degrade. The use of the lid portion 10 can improve the flatnesses of the non-cooling passage metal plates 3, 8.

The bonding area with the ceramic substrate 2 can be ensured by providing the cooling passage metal plate 4 with the lid portion 10. In other words, in the case where the bonding area with the ceramic substrate 2 can be ensured, the lid portion 10 may not be used. FIG. 3 shows an example in which the lid portion 10 is provided. FIG. 4 shows an example in which the lid portion 10 is not provided. When the lid portion 10 is provided, a sum of the thickness of the cooling passage metal plate 4 and a thickness of the lid portion 10 is used as the thickness T2.

It is preferable that a proportion of the volume of the cavity of the cooling passage portion 5 in the overall volume of the cooling passage metal plate 4 should fall within a range of more than or equal to 10% and less than or equal to 80%. If the proportion of the volume of the cooling passage portion 5 is less than 10%, the effect of providing the cooling passage portion might be insufficient. If the proportion of the volume of the cooling passage portion 5 exceeds 80%, the strength of the cooling passage metal plate 4 could degrade. In addition, bonding areas between the ceramic substrates 2, 7 and the cooling passage metal plate 4 might be insufficient. Thus, it is preferable that the proportion of the volume of the cooling passage portion 5 in the overall cooling passage metal plate 4 should fall within the range of more than or equal to 10% and less than or equal to 80% and further, more than or equal to 20% and 60%. In the case where the cooling passage metal plate 4 is provided with the plurality of cooling passage portions 5, a proportion of their total volume is used.

It is preferable that a width of the cooling passage portion 5 in the cross-section preferably should be more than or equal to 1 mm. In the case where the cross-section of the cooling passage portion 5 has a circular shape, the width of the cooling passage portion 5 in the cross-section means a length of a diameter of the cross-section of the cooling passage portion 5. In a case where the cross-section of the cooling passage portion 5 has another shape, the width of the cooling passage portion 5 in the cross-section means a shortest length among lengths between opposite points on the cross-section of the cooling passage portion 5. If the width of the cooling passage portion 5 is less than 1 mm, the flow of the cooling medium might be worsened. If the width of the cooling passage portion 5 is excessively narrow, a load during processing is imposed, and productivity degrades. An upper limit of the width of the cooling passage portion 5 is not particularly limited and preferably is less than or equal to 10 mm. If the width of the cooling passage portion 5 exceeds 10 mm, the flatness might be impaired. Thus, it is preferable that the width of the cooling passage portion 5 should fall within a range of more than or equal to 1 mm and less than or equal to 10 mm and further, more than or equal to 2 mm and less than or equal to 8 mm.

It is preferable that a creepage distance of the cooling passage portion 5 should be more than or equal to 1 mm. The creepage distance of the cooling passage portion 5 refers to a shortest distance between the cooling passage portion 5 and an end of the cooling passage metal plate 4. If the creepage distance of the cooling passage portion 5 is less than 1 mm, the cooling passage portion 5, if expanded even slightly, reaches the end of the cooling passage metal plate 4 to reduce the bonding area, which might cause water leakage. For example, the ceramic substrate 2 and the cooling passage metal plate 4 are bonded using the active metal brazing. If the creepage distance is short, an unbonded portion (such as a void), if any, in the bonding layer might cause water leakage. The unbonded portion is formed in some cases when a thermal stress is applied as in the TCT test. In other words, the durability can be improved by setting the creepage distance to more than or equal to 1 mm. Thus, it is preferable that the creepage distance of the cooling passage portion should be more than or equal to 1 mm and further, more than or equal to 2 mm.

It is preferable to use the active metal brazing for bonding the first ceramic substrate 2 and the metal plates 3, 4 and bonding the second ceramic substrate 7 and the metal plates 4, 8. The active metal brazing refers to a bonding method through use of one or two or more types of active metals selected from among Ti (titanium), Zr (zirconium), and Hf (hafnium). An active metal brazing material containing, as a principal constituent, copper (Cu) or silver (Ag) and containing an active metal is used. The principal constituent as herein referred to is a constituent contained most among metal constituents of the brazing material. When the active metal brazing is used, the ceramic substrate 2 and the metal plates 3, 4 are bonded with the interposition of active metal brazing layers, and the second ceramic substrate 7 and the metal plates 4, 8 are bonded with the interposition of active metal brazing layers.

It is preferable that an active metal brazing material composition should contain Ag (silver) more than or equal to 0% by mass and less than or equal to 60% by mass, Cu (copper) more than or equal to 15% by mass and less than or equal to 70% by mass, and Ti (titanium) or TiH₂ (titanium hydride) more than or equal to 1% by mass and less than or equal to 15% by mass. In a case of using both Ti and TiH₂, the total shall fall within the range of more than or equal to 1% by mass and less than or equal to 15% by mass. In a case of using both Ag and Cu, it is preferable that Ag should fall within a range of more than or equal to 20% by mass and less than or equal to 60% by mass, and Cu should fall within a range of more than or equal to 15% by mass and less than or equal to 40% by mass.

One or two types of Sn (tin) or In (indium) may be contained more than or equal to 1% by mass and less than or equal to 50% by mass according to necessity. It is preferable that a content of Ti or TiH₂ should fall within the range of more than or equal to 1% by mass and less than or equal to 15% by mass. C (carbon) may be contained more than or equal to 0.1% by mass and less than or equal to 2 % by mass according to necessity. One or two or more types selected from among tungsten (W), molybdenum (Mo), and rhenium (Re) may be added by more than or equal to 0.1% by mass and less than or equal to 10% by mass to the active metal brazing material. Carbon, tungsten, molybdenum, and rhenium can control a fluidity of the active metal brazing material.

Ratios of the active metal brazing material compositions shall be calculated assuming the total of raw materials to be blended as 100% by mass. In a case where the active metal brazing material is composed of three types of Ag, Cu, and Ti, for example, Ag + Cu + Ti = 100% by mass holds. In a case where the active metal brazing material is composed of four types of Ag, Cu, TiH₂, and In, Ag + Cu + TiH₂ + In = 100% by mass holds. In a case where the active metal brazing material is composed of five types of Ag, Cu, Ti, Sn, and C, Ag + Cu + Ti + Sn + C = 100% by mass holds.

Ag or Cu is a constituent to be a matrix of the brazing material. Sn or In has an effect of lowering a melting point of the brazing material. C (carbon) has effects of controlling the fluidity of the brazing material and reacting with other constituents to control a structure of the bonding layer. Thus, examples of constituents of the brazing material include Ag-Cu-Ti, Ag-Cu-Sn-Ti, Ag-Cu-Ti-C, Ag-Cu-Sn-Ti-C, Ag-Ti, Cu-Ti, Ag-Sn-Ti, Cu-Sn-Ti, Ag-Ti-C, Cu-Ti-C, Ag-Sn-Ti-C, and Cu-Sn-Ti-C. In may be used instead of Sn. Both Sn and In may be used.

The above-described active metal brazing material is effective in bonding copper plates. It is preferable that a metal portion should be a copper member, and the ceramic substrates 2, 7 and the copper member should be bonded with the interposition of Ag-free bonding layers. The Ag-free bonding layer refers to use of an active metal brazing material to which Ag is not added. The quantity of Ag may be less than or equal to 0.01% by mass (including 0) as an unavoidable impurity. The use of the Ag-free bonding layers can prevent Ag ion migration from occurring. The Ag ion migration refers to a phenomenon in which when a voltage is applied in a highly humid environment, Ag in a bonding layer is ionized and migrates. The Ag ion migrates and is deposited in another place. This causes an insulation failure. Among active metal brazing materials, Ag is most likely to produce ion migration. Without using Ag for the bonding layers, Ag ion migration can be prevented.

When the metal plates 3, 4, and 8 are aluminum plates, it is preferable to use an Al-Si-based or AlMg-based brazing material as the active metal brazing material. It is preferable that the content of one or two types of Si or Mg in the active metal brazing material should fall within a range of more than or equal to 0.1% by mass and less than or equal to 20% by mass.

The active metal brazing can increase bonding strength between the ceramic substrates 2, 7 and the metal plates 3, 4, 8. Thus, airtightness can be ensured when the cooling passage metal plate 4 is bonded to the ceramic substrates 2, 7 on one surface or both the surfaces.

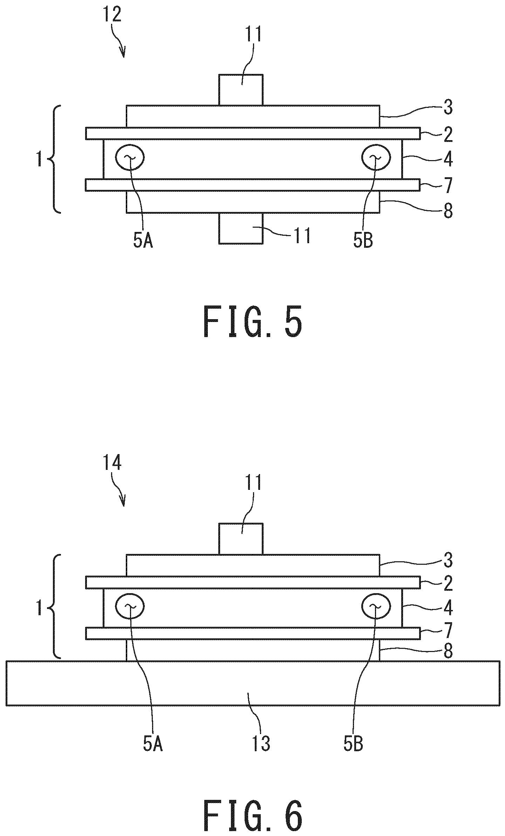

The ceramic circuit board 1 as described above can be used for a semiconductor device on which a semiconductor element is mounted. FIG. 5 shows an example of a semiconductor device according to the embodiment. The semiconductor device according to the embodiment in FIG. 5 illustrates the case in which the entrance 5A and the exit 5B are provided on the same side surface of the cooling passage metal plate 4. The case in which the entrance 5A and the exit 5B are provided on different side surfaces of the cooling passage metal plate 4 is not illustrated, and description is omitted as it is equivalent to FIG. 5. In the drawing, reference numeral 1 denotes a ceramic circuit board, reference numeral 11 denotes a semiconductor element, and reference numeral 12 denotes a semiconductor device. Although FIG. 5 illustrates the semiconductor device with the semiconductor elements 11 mounted on both surfaces, the semiconductor element 11 may be mounted only on one surface. A plurality of the semiconductor elements 11 may be mounted on one surface. Bonding wires, a lead frame, and the like neither shown may be provided.

A cooling medium is introduced through the entrance 5A of the cooling passage portion 5 of the semiconductor device 12. Examples of the cooling medium include cooling water and cooling gas. The semiconductor device 12 having high cooling efficiency can be accomplished by introducing the cooling medium from the entrance 5A to the exit 5B of the cooling passage portion 5. Since the cooling passage metal plate 4 is provided on a rear surface of the ceramic substrate 2, the semiconductor device 12 can also be reduced in thickness. Thus, both the cooling efficiency and thickness reduction can be achieved.

The ceramic circuit board 1 according to the embodiment can be attached without using a heat sink when being incorporated into a power module. In other words, a structure may be adopted in which the ceramic circuit board 1 is directly attached to a mounting board (or a base plate). The unnecessity to provide a heat sink is effective in reducing the number of components.

A conventional ceramic circuit board is installed in a cooler provided on a power module side with the interposition of a TIM (Thermal Interface Material) layer. The ceramic circuit board 1 according to the embodiment can be attached without providing the cooling passage metal plate 4 with a TIM layer. Examples of the TIM layer include a thermal grease and the like. In other words, the ceramic circuit board can be attached without providing a grease between the ceramic circuit board and a mounting board. The unnecessity to use a TIM layer is also effective in reducing the number of components.

FIG. 6 illustrates a structure in which the ceramic circuit board 1 is attached to a mounting board. In the drawing, reference numeral 1 denotes a ceramic circuit board, reference numeral 8 denotes a metal plate (rear metal plate), reference numeral 11 denotes a semiconductor element, reference numeral 12 denotes a semiconductor device, reference numeral 13 denotes a mounting board, and reference numeral 14 denotes a power module. The ceramic circuit board 1 on which the semiconductor element 11 is mounted is the semiconductor device 12. When the semiconductor device 12 is attached to the mounting board 13, the power module 14 is obtained.

A thermal grease layer has been conventionally provided between a ceramic circuit board and a heat sink or between a ceramic circuit board and a mounting board. The thermal grease is obtained by adding a filler to silicone resin or the like and has a thermal conductivity of approximately 1 to 2 W/m•K. The use of a grease lower in thermal conductivity than a ceramic substrate and a metal plate makes it difficult to release heat of a semiconductor element. Since the ceramic circuit board 1 according to the embodiment is provided with the cooling passage portion 5, the ceramic circuit board 1 itself has excellent heat dissipation performance. Thus, the ceramic circuit board 1 can be attached to the mounting board 13 without using a thermal grease between the non-cooling passage metal plate 8 and the mounting board 13. A structure in which a heat sink is not used is called a heatsink-less structure in some cases. A structure in which a grease is not used is called a greaseless structure in some cases. Attachment to the mounting board 13 may be conducted through screwing or the like according to necessity. Mold resin may be provided according to necessity.

Although the heatsink-less or greaseless structure has been illustrated above, a heat sink or grease may be used according to necessity. The foregoing indicates that even a heatsink-less or greaseless structure is adaptable. In the case where the ceramic circuit board 1 has a shape as in FIG. 1, the cooling passage metal plate 4 may be attached to the mounting board 13.

A method for using the semiconductor device 12 according to the embodiment is to perform temperature control by circulating the cooling medium in the cooling passage portion 5 or bringing the cooling medium into contact with the cooling passage portion 5. This enables heat during activation of the semiconductor element to be efficiently released.

### (Examples)

### (Examples 1 to 8)

As the ceramic substrates 2 of the ceramic circuit boards 1 according to Examples 1 to 8, a silicon nitride substrate, an aluminum oxide substrate, and an aluminum nitride substrate were prepared. The used silicon nitride substrate had a thermal conductivity of 90 W/m•K and a three-point bending strength of 650 MPa and was 100 mm in length × 90 mm in width. The used aluminum oxide substrate had a thermal conductivity of 20 W/m•K and a three-point bending strength of 430 MPa and was 100 mm in length × 90 mm in width. The used aluminum nitride substrate had a thermal conductivity of 170 W/m•K and a three-point bending strength of 400 MPa and was 100 mm in length × 90 mm in width. Copper plates were prepared as the metal plates. Oxygen-free copper plates were used as the copper plates. The ceramic circuit boards 1 according to Examples 1 to 7 included the second ceramic substrates 7 as shown in FIG. 2. The ceramic circuit board 1 according to Example 8 did not include the second ceramic substrate 7 or the non-cooling passage metal plate 8 as shown in FIG. 1.

The ceramic substrate 2 and the copper plate were bonded using the active metal brazing. A Ag-Cu-Sn-Ti-based brazing material was used as the active metal brazing material.

Thicknesses of copper plates relevant to the non-cooling passage metal plate 3, the cooling passage metal plate 4, and the non-cooling passage metal plate 8 and thicknesses of the ceramic substrate 2 in the ceramic circuit boards 1 according to Examples 1 to 7 are shown in Table 1. Vertical and horizontal sizes of the non-cooling passage metal plate 3, the cooling passage metal plate 4, and the non-cooling passage metal plate 8 are shown in Table 2. The non-cooling passage metal plate 3 is denoted as a front metal plate, and the non-cooling passage metal plate 8 is denoted as a rear metal plate. Shapes and the like of the cooling passage portion 5 provided in the copper plate relevant to the cooling passage metal plate 4 are shown in Table 3.

The ceramic circuit boards 1 according to Examples 1 to 7 were obtained by referring to the structure of FIG. 2.

A ceramic circuit board structured as shown in FIG. 1 was made as the ceramic circuit board 1 according to Example 8. A front metal plate was bonded to a front surface of the silicon nitride substrate as the ceramic circuit board 1, and the cooling passage metal plate 4 was bonded to a rear surface through the active metal brazing. The non-cooling passage metal plate 3 is denoted as the front metal plate. Copper plates (oxygen-free copper plates) were used as the front metal plate and the cooling passage metal plate 4.

**[Table 1]**

| | Ceramic Substrate | |
|---|---|---|
| | Type | Thicknesses T1,T3 [mm] |
| Example 1 | Silicon Nitride Substrate | 0.32 |
| Example 2 | Silicon Nitride Substrate | 0.32 |
| Example 3 | Silicon Nitride Substrate | 0.25 |
| Example 4 | Silicon Nitride Substrate | 0.635 |
| Example 5 | Aluminum Oxide Substrate | 0.635 |
| Example 6 | Aluminum Nitride Substrate | 4 |
| Example 7 | Aluminum Oxide Substrate | 2 |
| Example 8 | Silicon Nitride Substrate | 0.32 (T1 Only) |

| | Thickness T4 [mm] of Front Metal Plate | Thickness T2 [mm] of Cooling Passage Metal Plate | Thickness T5 [mm] of Rear Metal Plate |
|---|---|---|---|
| Example 1 | 1.0 | 4 | 1.0 |
| Example 2 | 1.3 | 5 | 1.3 |
| Example 3 | 1.5 | 7 | 1.5 |
| Example 4 | 2.0 | 12 | 2.0 |
| Example 5 | 1.0 | 8 | 1.0 |
| Example 6 | 0.5 | 8 | 0.5 |
| Example 7 | 0.5 | 1 | 0.5 |
| Example 8 | 1.5 | 4 | - |

**[Table 2]**

| | Vertical and Horizontal Sizes [mm] of Front Metal Plate | Vertical and Horizontal Sizes [mm] of Cooling Passage Metal Plate | Vertical and Horizontal Sizes [mm] of Rear Metal Plate |
|---|---|---|---|
| Example 1 | 96×86 | 96×86 | 96×86 |
| Example 2 | Three of 30×86 | 96×86 | 96×86 |
| Example 3 | 96×86 | 96×86 | 96×86 |
| Example 4 | Three of 30×86 | 96×86 | 96×86 |
| Example 5 | 96×86 | 96×86 | 96×86 |
| Example 6 | 96×86 | 96×86 | 96×86 |
| Example 7 | 96×86 | 96×86 | 96×86 |
| Example 8 | 96×86 | 96×86 | 96×86 |

| | T2/T1, T2/T3 | T2/T4 | T2/T5 |
|---|---|---|---|
| Example 1 | 12.5 | 4.0 | 4.0 |
| Example 2 | 15.6 | 3.8 | 3.8 |
| Example 3 | 28 | 4.7 | 4.7 |
| Example 4 | 18.9 | 6.0 | 6.0 |
| Example 5 | 12.6 | 8.0 | 8.0 |
| Example 6 | 2 | 16 | 16 |
| Example 7 | 0.5 | 2.0 | 2.0 |
| Example 8 | 12.5 | 2.7 | 2.7 |

**[Table 3]**

| | Cooling Passage Portion | | |
|---|---|---|---|
| | Shape | Entrance and Exit being on Same Side | Presence or Absence of Folded Portion |
| Example 1 | Curved Type | YES | Presence |
| Example 2 | Curved Type | YES | Presence |
| Example 3 | Curved Type | YES | Presence |
| Example 4 | Linear Type | NO | Absence |
| Example 5 | Linear Type | NO | Absence |
| Example 6 | Linear Type | NO | Absence |
| Example 7 | Linear Type | NO | Absence |
| Example 8 | Curved Type | YES | Presence |

| | Cooling Passage Portion | |
|---|---|---|
| | Proportion [%] of Volume in Cooling Passage Metal Plate | Presence or Absence of Lid Portion |
| Example 1 | 20 | Absence |
| Example 2 | 30 | Presence |
| Example 3 | 60 | Presence |
| Example 4 | 40 | Absence |
| Example 5 | 40 | Presence |
| Example 6 | 40 | Absence |
| Example 7 | 30 | Absence |
| Example 8 | 25 | Absence |

The vertical and horizontal sizes of the front and rear metal plates shown in Table 2 indicate the length in millimeter × width in millimeter. The cooling passage metal plate 4 had a shape in which a groove was formed from one surface. A copper plate having a thickness of 0.3 mm was used as the lid portion 10. In the case where the cooling passage portion 5 was of the curved type, the single entrance 5A and the single exit 5B were provided. In the case where the cooling passage portion 5 was of the linear type, a plurality of the cooling passage portions 5 were provided such that the proportion of the volume had a predetermined value. In each case, the width of the cooling passage portion 5 was set to fall within a range of more than or equal to 1 mm and less than or equal to 10 mm. The creepage distance of the cooling passage portion 5 was set to more than or equal to 1 mm.

The flatnesses of the ceramic circuit boards 1 according to Examples 1 to 8 were examined. The flatnesses of the front metal plate and the rear metal plate were measured. In the ceramic circuit boards 1 according to Examples 1 to 7, the flatnesses of the non-cooling passage metal plate 3 serving as the front metal plate and the non-cooling passage metal plate 8 serving as the rear metal plate were measured. On the other hand, in the ceramic circuit board 1 according to Example 8, the flatnesses of the non-cooling passage metal plate 3 serving as the front metal plate and the cooling passage metal plate 4 were measured. A difference between a highest location and a lowest location of the surface of the front metal plate was measured using a three-dimensional shape measuring machine. Similar measurement was also performed for the rear metal plate. Results are shown in Table 4.

**[Table 4]**

| | Flatness [mm] | |
|---|---|---|
| | Front Metal Plate | Rear Metal Plate |
| Example 1 | 0.7 | 0.6 |
| Example 2 | 0.2 | 0.2 |
| Example 3 | 0.2 | 0.2 |
| Example 4 | 0.7 | 0.8 |
| Example 5 | 0.4 | 0.3 |
| Example 6 | 0.8 | 0.8 |
| Example 7 | 1.2 | 1.2 |
| Example 8 | 1.0 | 1.3 (Cooling Passage Metal Plate) |

As shown in Table 4, in the ceramic circuit boards 1 according to Examples 1 to 8, both the metal plates had flatnesses of less than or equal to 1.5 mm, so that sufficient flatnesses were able to be secured. In the ceramic circuit boards 1 according to Examples 1 to 6 among Examples 1 to 8, both the front and rear metal plates had flatnesses of less than or equal to 1.0 mm. In the ceramic circuit boards 1 according to Examples 2, 3, and 5 in which the lid portion 10 was used, both the front and rear metal plates had small flatnesses of less than or equal to 0.4 mm. In the ceramic circuit boards 1 according to Examples 2 and 3 in which the silicon nitride substrate and the lid portion 10 were used, the front and rear metal plates had still smaller flatnesses of less than or equal to 0.2 mm.

In Example 7, both the front and rear metal plates had flatnesses exceeding 1.0 mm. Since the thickness of the cooling passage metal plate 4 was small in the ceramic circuit board 1 according to Example 7, distortion of the ceramic circuit board 1 was significant. The ceramic circuit board 1 according to Example 8 had a structure in which the second ceramic substrate 7 was not used. In this case, the flatness of the front metal plate was good. The flatness of the cooling passage metal plate 4 exceeded 1.0 mm. Thus, it is understood that in the case where the second ceramic substrate is used, the flatnesses of the metal plates are more favorable.

Next, the cooling efficiency was examined. The semiconductor device 12 in which the semiconductor element 11 was mounted on each of the ceramic circuit boards 1 according to Examples 1 to 8 was made. Next, a device (hereinafter called a semiconductor device A) in which the semiconductor device 12 according to each of Examples 1 to 8 was attached to a mounting board with a grease was made. The grease was provided with a thickness of 0.7 mm. A device (hereinafter called a semiconductor device B) in which the semiconductor device 12 according to each of Examples 1 to 8 was attached to a mounting board without a grease was made.

Each of the semiconductor devices A and B was energized, and when a steady state was brought about, a raised temperature was measured. Temperature measurement was performed while cooling water as the cooling medium flows to the cooling passage portion 5. Five devices each were made, and a lower limit value and an upper limit value of the raised temperature are shown. Results are shown in Table 5.

**[Table 5]**

| | Raised Temperature [degree Celsius] | |
|---|---|---|
| | Semiconductor Device A (With Grease) | Semiconductor Device B (Greaseless) |
| Example 1 | 58-68 | 4-16 |
| Example 2 | 58-67 | 3-15 |
| Example 3 | 47-60 | 1-10 |
| Example 4 | 45-55 | 1-8 |
| Example 5 | 47-60 | 2-10 |
| Example 6 | 46-60 | 2-10 |
| Example 7 | 60-80 | 8-22 |
| Example 8 | 53-74 | 7-18 |

As is understood from Table 5, since the ceramic circuit boards 1 according to Examples 1 to 8 were provided with the cooling passage portions 5, the cooling efficiency was improved. A heat sink radiator plate or a water-cooling sink unit may not be used in the ceramic circuit boards 1 according to Examples 1 to 8 unlike Patent Document 2. This enables thickness reduction of semiconductor devices. Since a heat sink radiator plate or a water-cooling sink unit may not be provided separately, thermal resistance can be reduced. Even a greaseless structure was able to be used. Consequently, the ceramic circuit boards according to Examples 1 to 8 can be improved in cooling efficiency.

As described above, with the ceramic circuit board 1 according to the embodiment, the cooling efficiency of the semiconductor element 11 can be improved, and a ceramic circuit board having good productivity can be provided.

While certain embodiments have been described, these embodiments have been presented by way of example only, and are not intended to limit the scope of the inventions. Indeed, the novel methods and systems described herein may be embodied in a variety of other forms; furthermore, various omissions, substitutions and changes in the form of the methods and systems described herein may be made without departing from the spirit of the inventions. The accompanying claims and their equivalents are intended to cover such forms or modifications as would fall within the scope and spirit of the inventions.

## Claims

1. A ceramic circuit board comprising:
a ceramic substrate; and
metal plates each bonded to both surfaces of the ceramic substrate, wherein
the metal plate bonded to at least one of both the surfaces of the ceramic substrate is a cooling passage metal plate including a cooling passage portion.

2. The ceramic circuit board according to claim 1, wherein the ceramic substrate has a thickness smaller than a thickness of the cooling passage metal plate.

3. The ceramic circuit board according to claim 1 or 2, wherein
the ceramic substrate includes a first ceramic substrate and a second ceramic substrate bonded to the metal plate bonded to the first ceramic substrate,
one of surfaces of the second ceramic substrate is bonded to the cooling passage metal plate bonded to the first ceramic substrate, and
a metal plate is bonded to another of the surfaces of the second ceramic substrate.

4. The ceramic circuit board according to any one of claims 1 to 3, wherein an entrance and an exit of the cooling passage portion of the cooling passage metal plate are provided on a same side surface of the cooling passage metal plate.

5. The ceramic circuit board according to any one of claims 1 to 3, wherein the cooling passage portion of the cooling passage metal plate includes a plurality of folded portions.

6. The ceramic circuit board according to any one of claims 1 to 5, wherein the ceramic substrate is a silicon nitride substrate.

7. The ceramic circuit board according to any one of claims 1 to 6, wherein the metal plates are copper plates.

8. The ceramic circuit board according to any one of claims 1 to 7, wherein the ceramic substrate and the metal plates are bonded with an interposition of active metal brazing layers.

9. The ceramic circuit board according to any one of claims 1 to 8, wherein the metal plate bonded to one of both the surfaces of the ceramic substrate is the cooling passage metal plate, and the metal plate bonded to another of the surfaces is a non-cooling passage metal plate not including the cooling passage portion.

10. A semiconductor device wherein a semiconductor element is mounted on the non-cooling passage metal plate of the ceramic circuit board according to claim 9.

11. A method for using the semiconductor device according to claim 10, comprising circulating a cooling medium in the cooling passage portion of the cooling passage metal plate or bringing the cooling medium into contact with the cooling passage portion to perform temperature control.
